# EUROPEAN PATENT APPLICATION

(11) **EP 3 322 270 A1**
(43) Date of publication of application: **16.05.2018**
(21) Application number: 16824302.0
(22) Date of filing: 01.07.2016
(51) Int. Cl.: H05K 7/20, H01L 23/36

(54) **HEATSINK**

(30) Priority: 10.07.2015 JP 2015138934
(71) Applicant: Sumitomo Seika Chemicals Co., Ltd., Kako-gun, Hyogo 675-0145 (JP); Chiyoda Integre Co., Ltd., Tokyo 1040044 (JP)
(72) Inventor: MORIYAMA Hirotake, Kako-gun Hyogo 675-0145 (JP); HAYASHI Akihiro, Soka-shi Saitama 340-0002 (JP)
(74) Representative: Boult Wade Tennant
(86) International application number: PCT/JP2016/069664
(87) International publication number: WO 2017/010322

(57) **Abstract**

[Problem] To provide a heat sink that is lightweight, easy to be worked, and has a good cooling capability.

[Solution] A heat sink X1 of the present invention includes a quasi-tubular shell 1 that is attached to a cooling target O1 and formed by a heat dissipating sheet. The heat dissipating sheet has a heat transfer layer 1A and a heat radiation layer 1B laminated on the heat transfer layer 1A. The heat radiation layer 1B constitutes at least a portion of an outer surface of the shell 1 located away from the cooling target O1.

## Description

### [FIELD OF THE INVENTION]

The present invention relates to a heat sink, and in particular to a heat sink suitable for cooling a component such as an IC for a flat panel television or a base for an LED lamp.

### [BACKGROUND ART]

In recent years, as a countermeasure against heat, a component such as an IC for a flat panel television or an LED base is designed to include a heat sink made of metal, such as aluminum, so as to release heat to an air layer and cool the component to or below a limit temperature. Such a heat sink uses a highly heat-conductive metal, and an effort has been made to improve the heat radiation characteristic of the heat sink by casting, forging, cutting, or extruding a metal such as aluminum to create multiple fins to increase the surface area (see Patent Documents 1 and 2, for example) . In more recent years, a heat sink has been available that uses a highly heat-conductive sheet, such as a carbon fiber sheet or a graphite sheet, or metal foil, that is lightweight and has easy workability.

An LED lamp has an advantage of being highly efficient, small, and lightweight, and there is a particularly high demand for a lamp arranged at a high place to be reduced in weight. Accordingly, associated parts including a heat sink are also required to be more lightweight. Since a flat television has a limited space around an IC, the heat sink is required to have a high degree of freedom in shape and to have enhanced moldability. Also, since the IC is arranged parallel to the display, a vertical heat sink with good cooling performance is required. However, the metal heat sinks disclosed in Patent Documents 1 and 2 are heavy and have a low degree of freedom in shape.

On the other hand, the heat sink that uses a highly heat-conductive sheet such as a carbon fiber sheet or a graphite sheet, which is disclosed in Patent Document 3, is good in terms of weight reduction and a degree of freedom in shape, but has poor cooling performance since carbon fiber sheets and graphite sheets have lower heat conductivity than metal. Furthermore, although the heat sink formed with the metal foil disclosed in Patent Document 3 is reduced in weight and has a high degree of freedom in shape, the cooling capability thereof is lower than that of the metal heat sinks in Patent Documents 1 and 2. This is because metal has an extremely small emissivity, which results in having almost no cooling effect by radiation.

### [PRIOR ART DOCUMENT(S)]

Patent Document 1: JP-A-H10-116942
Patent Document 2: JP-A-2005-93097
Patent Document 3: JP-A-2013-4544

### [SUMMARY OF THE INVENTION]

The present invention, which has been conceived under the above circumstances, has as its main object to provide a heat sink that is lightweight, easy to be worked, and has a good cooling capability.

As a result of intensive studies to solve the above problem, the present inventors have found that a heat sink that is lightweight, easy to be worked, and has a good cooling capability is obtained by using a heat dissipating sheet having a heat transfer layer and a heat radiation layer laminated on the heat transfer layer, and have further conducted studies to complete the present invention.

A first aspect of the present invention provides a heat sink including: a shell attached to a cooling target, and having an inner space defined by a heat dissipating sheet, the heat dissipating sheet having a heat transfer layer and a heat radiation layer laminated on the heat transfer layer, wherein the heat radiation layer constitutes at least a portion of an outer surface of the shell located away from the cooling target.

In a preferable embodiment, the heat sink further comprises a metal sheet interposed between the cooling target and the shell. Preferably, the metal sheet comprises a flat plate.

Preferably, the heat sink may further include an intermediate member interposed between the cooling target and the shell.

Preferably, the intermediate member comprises a channel member. Alternatively, the intermediate member may comprise a corrugated plate.

Preferably, the heat radiation layer constitutes the entire outer surface of the shell.

Preferably, the heat radiation layer has a thermal emissivity of at least 0.8.

Preferably, the shell has a quasi-tubular structure, and has two open ends in a tube axis direction.

Preferably, the heat transfer layer is a metal layer, and the heat radiation layer contains a water-insoluble inorganic compound and a heat-resistant synthetic resin, and a content of the water-insoluble inorganic compound in the heat radiation layer is 30 to 90 wt.% relative to the entire heat radiation layer.

Preferably, the metal layer contains aluminum and/or copper.

Preferably, the water-insoluble inorganic compound is at least one selected from the group consisting of silica compounds, silica alumina compounds, aluminum compounds, calcium compounds, nitrides, phyllosilicates, and coal ash.

Preferably, the heat-resistant synthetic resin is at least one selected from the group consisting of polyimide resins, polyamide-imide resins, epoxy resins, and acrylic resins.

According to a second aspect of the present invention, a cooling structure is provided that includes a cooling target, and the above-described heat sink attached to the cooling target.

Other features and advantages of the present invention will become more apparent from the detailed descriptions given below with reference to the accompanying drawings.

### [BRIEF DESCRIPTION OF THE DRAWINGS]

Fig. 1 is a perspective view showing a first embodiment of a heat sink according to the present invention.
Fig. 2 is a perspective view showing a shell included in the heat sink of Fig. 1.
Fig. 3 is a perspective view showing an example of a metal sheet included in the heat sink of Fig. 1.
Fig. 4 is a longitudinal sectional view showing the heat sink of Fig. 1.
Fig. 5 is a perspective view showing a second embodiment of a heat sink according to the present invention.
Fig. 6 is a perspective view showing a shell included in the heat sink of Fig. 5.
Fig. 7 is a longitudinal sectional view showing the heat sink of Fig. 5.
Fig. 8 is a perspective view showing a third embodiment of a heat sink according to the present invention.
Fig. 9 is a perspective view showing an example of a metal sheet included in the heat sink of Fig. 8.
Fig. 10 is a longitudinal sectional view showing the heat sink of Fig. 8.
Fig. 11 is a perspective view showing a fourth embodiment of a heat sink according to the present invention.
Fig. 12 is a longitudinal sectional view showing the heat sink of Fig. 11.
Fig. 13 shows an actual image of a heat sink manufactured by conventional extrusion molding.
Fig. 14 is a perspective view showing a measurement device.
Fig. 15 is a longitudinal sectional view showing the measurement device.
Fig. 16 is a perspective view showing the measurement device.

### [MODE FOR CARRYING OUT THE INVENTION]

Preferred embodiments of the present invention are described in detail below with reference to the accompanying drawings.

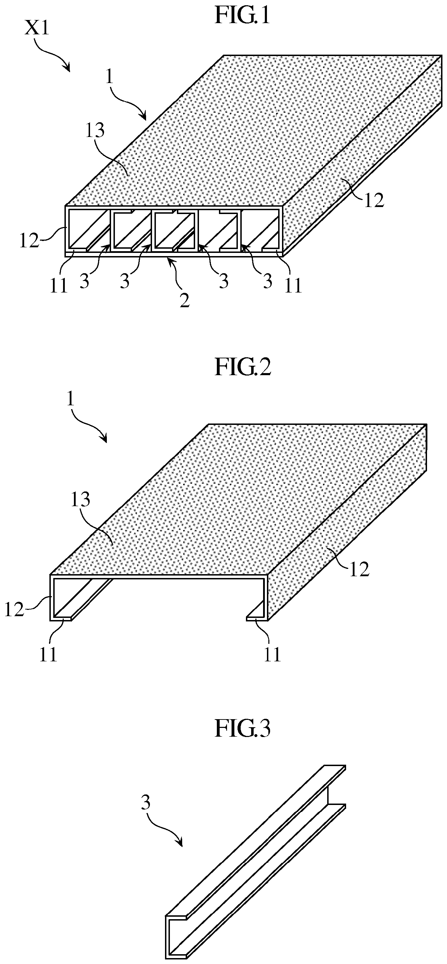

Fig. 1 shows a first embodiment of a heat sink according to the present invention. A heat sink X1 of the present embodiment includes a quasi-tubular shell 1, a metal sheet 2, and intermediate members 3. In use, the heat sink X1 is attached to a cooling target that is an object to be cooled, such as a heat generating portion of any of the home appliances including a flat panel television, an LED lamp, a refrigerator, a washing machine, an air conditioner, a printer, and a personal computer; a heat-generating portion of an in-vehicle device, a transporting vehicle light, a work light, a heater, a projector, and a copier; or an electronic board. As usedherein, a "tubular" shape may be cross-sectionally circular or polygonal, e.g., rectangular.

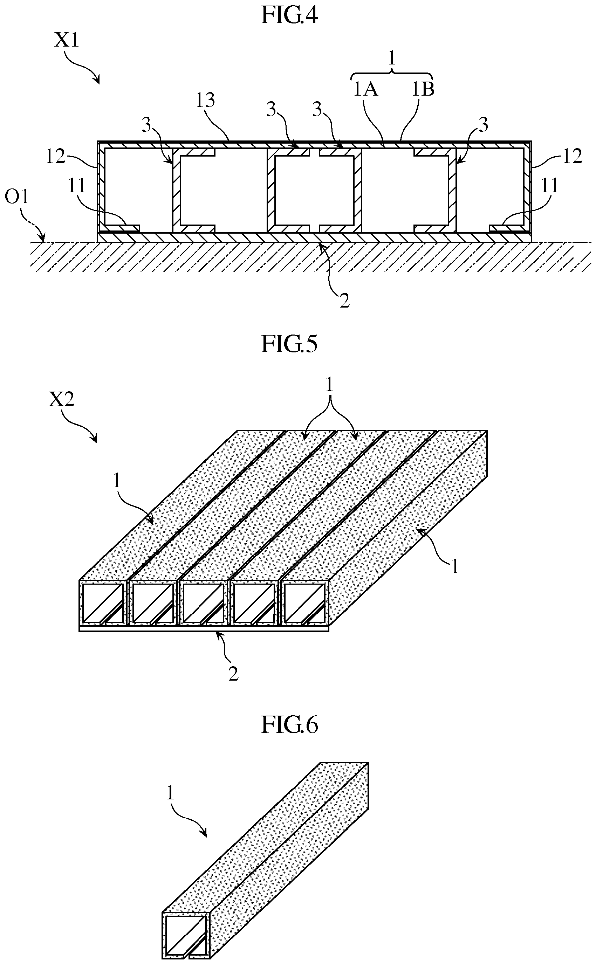

The shell 1 is formed of a heat dissipating sheet having a predetermined laminate structure. As shown in Fig. 4, the heat dissipating sheet applied for the shell 1 has a heat transfer layer 1A, and a heat radiation layer 1B laminated on the heat transfer layer 1A.

The heat transfer layer 1A is made of a metal layer, for example. Although the heat transfer layer 1A may be made of any metal having high heat conductivity, it is preferably made of a metal having a heat conductivity of 30 W/m·K or higher, and more preferably a metal having a heat conductivity of 200 W/m·K or higher. A heat conductivity lower than 30 W/m·K may lead to a poor cooling effect. Specific examples of metal used for the heat transfer layer include copper, aluminum, gold, silver, tin, nickel, and iron. These metals may be used individually, or may be combined with each other or with another metal to form an alloy. In view of availability, cost, and workability, aluminum and copper are particularly preferable among the metals mentioned above.

The heat transfer layer 1A has a thickness of, for example, 15 µm to 2 mm, and preferably 50 µm to 500 µm. If the heat transfer layer 1A is thinner than 15 µm, it may exhibit insufficient heat transfer performance and poor cooling effect. If the heat transfer layer 1A is thicker than 2 mm, the heat sink X1 may be unduly heavy, and the heat transfer layer 1A may be less flexible to result in difficulty of working.

The heat radiation layer 1B may be made of, but not limited to, a heat dissipative material, such as alumite, a heat dissipative coating composition, graphite, or synthetic resin. The heat radiation layer 1B is preferably formed by applying a heat radiation coating composition to the heat transfer layer 1A as described below. When heat is transferred from the heat transfer layer 1A, the heat radiation layer 1B radiates the heat as infrared rays. The heat radiation layer 1B has a thermal emissivity of at least 0.8, for example, preferably 0.85 or higher, and more preferably 0.9 or higher. In the present embodiment, the heat dissipating sheet made up of the heat transfer layer 1A and the heat radiation layer 1B is bent into the shape of the quasi-tubular shell 1 as shown in Fig. 2.

The heat radiation layer preferably includes a water-insoluble inorganic compound and a heat-resistant synthetic resin. As used herein, "water-insoluble" means that the solubility in 100 ml of water at 20°C is less than 1.0 g. The water-insoluble inorganic compound is preferably at least one selected from the group consisting of, for example, silica compounds, silica alumina compounds, aluminum compounds, calcium compounds, nitrides, phyllosilicates, layered double hydroxides, and coal ash. Among those stated above, silica compounds, silica alumina compounds, phyllosilicates, and coal ash are more preferable, and phyllosilicates and coal ash are particularly preferable in terms of emission characteristic (thermal emissivity) . The coal ash refers to the ash generated when coal is burned in a thermal power plant, such as fly ash or clinker ash. The coal ash is a mixture of water-insoluble inorganic compounds in which silica and alumina, which are the main components of the coal ash, constitute 80% to 95% of all components.

Examples of phyllosilicate include natural or synthetic mica, talc, kaolin, pyrophyllite, sericite, vermiculite, smectite, bentonite, stevensite, montmorillonite, beidellite, saponite, hectorite, and nontronite. Among these, non-swellable clay minerals such as talc, kaolin, pyrophyllite, non-swellable mica, and sericite are preferable because these minerals allow for production of uniform heat dissipating sheets at low cost, and it is even more preferable that the phyllosilicate is at least one selected from the group consisting of talc, kaolin, pyrophyllite, and non-swellable mica.

Examples of the heat-resistant synthetic resin contained in the heat radiation layer include, but not limited to, a polyimide resin, a polyamide-imide resin, a fluororesin, a polyphenylene sulfide resin, a polysulfone resin, a polyarylate resin, a polyethersulfone resin, a polyetherimide resin, a polyetheretherketone resin, a polybenzoxazole resin, a polybenzimidazole resin, an epoxy resin, and an acrylic resin. These resins can be used individually or, alternatively, two or more of these resins may be used in combination. Among those stated above, a polyimide resin and a polyamide-imide resin are preferably used when priority is given to film formability and heat resistance, and an epoxy resin and an acrylic resin are preferably used when priority is given to ease of handling and cost effectiveness. The polyimide resin and the polyamide-imide resin are not particularly limited, but an aromatic polyimide resin and an aromatic polyamide-imide resin are preferably used because of good heat resistance. The epoxy resin is not particularly limited, but a novolac epoxy resin is preferable, such as a phenol novolac type or a cresol novolac type resin. Use may also be made of a bisphenol A type or a bisphenol F type resin. As the acrylic resin, a polymer solution dissolved in an organic solvent can be used, and a water-soluble acrylic resin or an emulsion dispersed in water is preferably used from the standpoint of ease of handling. In addition, the acrylic resin may be formed of a copolymer with a monomer such as styrene, urethane, vinyl acetate, silicone, or acrylate.

The heat dissipating sheet forming the shell 1 can be made by applying, to the heat transfer layer 1A, a heat radiation coating composition containing a water-insoluble inorganic compound and a heat-resistant synthetic resin, and/or a heat radiation coating composition containing a water-insoluble inorganic compound and a precursor of a heat-resistant synthetic resin.

The precursor of the heat-resistant synthetic resin may be polyamide acid, for example, where the polyamide acid is imidized to obtain a polyimide resin or a polyamide-imide resin. Examples of method for imidizing the polyamide acid include a method for imidizing by thermally ring-closing the polyamide acid, and a method for imidizing by chemically ring-closing the polyamide acid.

The heat radiation coating composition containing the water-insoluble inorganic compound contains 30 to 90 wt.% of water-insoluble inorganic compound relative to the entire heat radiation layer 1B formed after application and drying of the heat radiation coating composition, and a balance of a heat-resistant synthetic resin. The thickness of the heat radiation layer 1B, which is formed of the heat radiation coating composition containing the water-insoluble inorganic compound, is 20 µm to 100 µm, for example. If the thickness of the heat radiation layer 1B is less than 20 µm, the radiative heat dissipating performance may be insufficient. On the other hand, if the thickness of the heat radiation layer 1B exceeds 100 µm, it is economically disadvantageous because of an increase in the amount of material used. In addition, the heat radiation layer 1B may function as a heat insulating layer and may, as a result, have a poor cooling capability.

The following description refers to the shape of the heat sink X1 according to the present embodiment. In the present embodiment, the shell 1 includes a pair of bent portions 11, a pair of upright portions 12, and a ceiling portion 13 extending between the ends of the paired upright portions 12, and has a quasi-rectangular cross-sectional shape, as shown in Fig. 2. Also, as clearly shown in Fig. 4, the shell 1 is formed such that the heat radiation layer 1B is arranged on the outer side. In Figs. 1 and 2, the formation area of the heat radiation layer 1B is shaded.

As shown in Figs. 1 and 4, the metal sheet 2 and the intermediate members 3 are provided between the shell 1 and a cooling target O1. The metal sheet 2 is a flat plate having a predetermined thickness. As shown in Fig. 3, each of the intermediate members 3 is formed by bending a metal plate having a predetermined thickness into a channel. The bent portions 11 of the shell 1 are joined to the metal sheet 2 such that, in the present embodiment, the metal sheet 2 and the shell 1 form a rectangular tube. A plurality (four in the present embodiment) of the intermediate members 3 are provided to partition the inner space of the rectangular tube.

The metal sheet 2 and the intermediate members 3 are not particularly limited in terms of material, but are preferably made of a metal having a heat conductivity of 30 W/m·K or higher, and more preferably a metal having a heat conductivity of 200 W/m·K or higher. Specifically, the metal constituting the metal sheet 2 and the intermediate members 3 is preferably copper, aluminum, gold, silver, tin, nickel, iron, an alloy of these metals, or other alloy containing at least one of these metals, for example. In particular, aluminum and copper are preferable from the standpoint of availability, cost and workability. The metal sheet 2 and the intermediate members 3 may be made of the same metal as or a different metal from the heat transfer layer 1A of the shell 1.

Each of the metal sheet 2 and the intermediate members 3 is preferably as thick as or thicker than the heat transfer layer 1A of the shell 1. Each of the metal sheet 2 and the intermediate members 3 has a thickness of 50 µm to 2 mm, for example.

The method for joining the structural members (the shell 1, the metal sheet 2, and the intermediate members 3) of the heat sink X1 is not particularly limited. For example, the structural members may be joined together by adhesion, or may be joined by a combination of notches and protrusions such as a dovetail joint. The method for adhesion may use an adhesive agent or an adhesive tape. Furthermore, the joining may be achieved by welding or cold joining. Also, the members may be fixed via a silicone grease, a heat conductive grease, or a heat conductive sheet (which is referred to as a "thermal interface material").

As can be understood from Fig. 4, in the present embodiment, the heat radiation layer 1B constitutes the outer surface of the shell 1, away from the cooling target O1. Both ends of the shell 1 in a tube axis direction are open.

According to the heat sink X1 in the present embodiment, the heat of the cooling target O1 is transferred to the entire heat dissipating sheet (shell 1) via the heat transfer layer 1A having high heat conductivity before being dissipated. the shell 1 includes the heat radiation layer 1B that forms an outer surface of the shell. Such a structure allows the heat radiation layer 1B to produce a high cooling effect by radiation.

Furthermore, in the heat sink X1, the metal sheet 2 and the intermediate members 3 are interposed between the shell 1 and the cooling target O1. The structure including the metal sheet 2 and the intermediate members 3 that have high heat conductivity enhances the heat dissipation efficiency, which further improves the cooling effect.

In addition, the heat sink X1 may be attached to the cooling target O1 in an upright posture in a manner such that the tube axis of the shell 1 is oriented in the vertical direction, thereby causing the air warmed in the inner space of the shell 1 to move upward. In this way, the air in the inner space automatically flows upward from the bottom (which is referred to as "chimney effect"), and the cooling effect is significantly improved. Due to the cooling effects mentioned above (heat conduction, radiation, and chimney effect), the heat sink X1 is capable of providing good cooling efficiency while being lightweight.

Figs. 5 to Fig. 7 show a second embodiment of the heat sink according to the present invention. Note that from Fig. 5 onwards, elements that are the same as or similar to those in the foregoing embodiment are denoted by the same reference signs as in the foregoing embodiment, and descriptions thereof are omitted as appropriate.

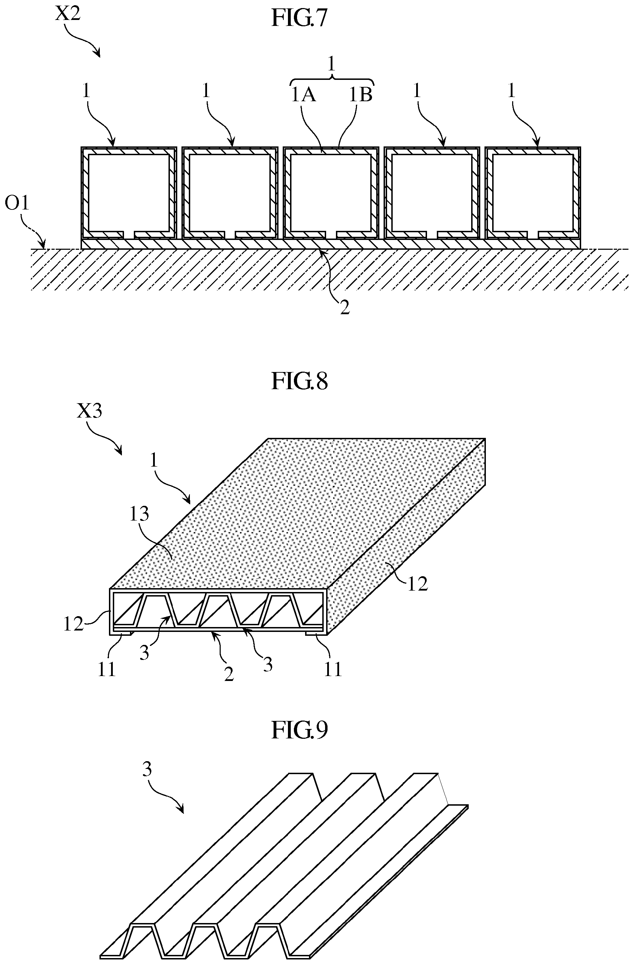

A heat sink X2 according to the present embodiment includes a plurality of shells 1 that are quasi-tubular and a metal sheet 2. Each shell 1 has a different shape from that in the first embodiment. However, the shell 1 is formed of a heat dissipating sheet, which includes a heat transfer layer 1A and a heat radiation layer 1B (see Fig. 7), similarly to the heat sink X1 described above.

In the present embodiment, each shell 1 is bent into a generally square shape in cross section such that the heat radiation layer 1B is arranged on the outer side. A plurality of (five in the present embodiment) thus structured shells 1 are then juxtaposed on the flat metal sheet 2 side by side and bonded to the metal sheet 2. Note that, in Figs. 5 and 6, the formation area of the heat radiation layer 1B is shaded.

The heat sink X2 of the present embodiment also produces the same effect as the above-described heat sink X1.

Figs. 8 to 10 show a third embodiment of the heat sink according to the present invention . A heat sink X3 of the present embodiment includes a quasi-tubular shell 1, a metal sheet 2, and an intermediate member 3. The shell 1 is substantially the same as the shell 1 (see Fig. 2) in the first embodiment. In other words, the shell 1 is formed such that the heat radiation layer 1B is disposed on the outside. Note that, in Fig. 8, the formation area of the heat radiation layer 1B is shaded.

The metal sheet 2 is a flat plate, similarly to the above embodiments. The metal sheet 2 is placed on bent portions 11 in the shell 1 and joined to the bent portions 11. As such, the metal sheet 2 and the shell 1 form a rectangular tubular shape in the present embodiment.

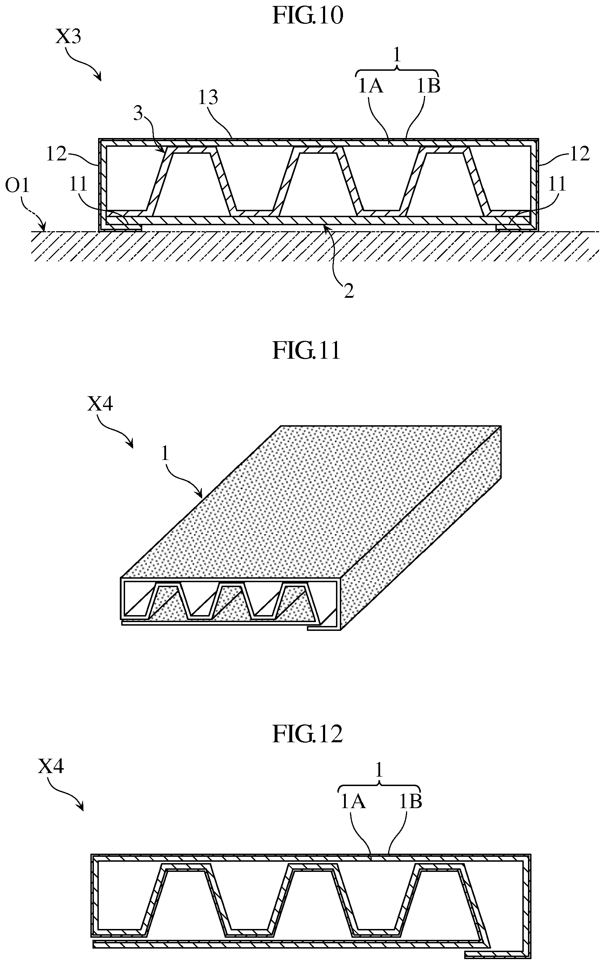

As shown in Fig. 9, the intermediate member 3 of the present embodiment is formed by bending a metal plate having a predetermined thickness into a corrugated form. The intermediate member 3 is disposed in an inner space defined by the metal sheet 2 and the shell 1 and having a rectangular tubular shape as described above. As shown in Fig. 10, the intermediate member 3 has a cross section that is corrugated in a direction orthogonal to the tube axis of the shell 1.

The heat sink X3 of the present embodiment also produces the same effect as the above-described heat sink X1.

Figs. 11 and 12 show a fourth embodiment of the heat sink according to the present invention. A heat sink X4 of the present embodiment includes a quasi-tubular shell 1. The shell 1 is formed by bending a heat dissipating sheet, and includes a surrounding portion having a rectangular tubular shape, and a corrugated plate portion located inside and connected to the surrounding portion. The shell 1 according to the present embodiment is formed such that the heat radiation layer 1B constitutes the outer side of the surrounding portion. Note that, in Fig. 11, the formation area of the heat radiation layer 1B is shaded.

The heat sink X4 of the present embodiment also produces the same effect as the above-described heat sink X1.

Although specific embodiments of the present invention have been described, the present invention is not limited thereto, and various modifications are possible without departing from the spirit of the invention. Various modifications to the structure of each component of the heat sink are possible according to the present invention.

The heat sink according to the present invention is characterized by the heat radiation layer 1B that constitutes the outer surface of the shell. However, an additional heat radiation layer may be further provided to constitute the inner surface of the shell. In addition, heat radiation layers may also be provided on surface portions corresponding to the metal sheet 2 and the intermediate members 3 in the above embodiments .

The heat radiation layer 1B may be provided after a heat sink is formed. The heat radiation layer does not always need to constitute the entire outer surface of the shell, and may constitute only a part of the outer surface of the shell.

Furthermore, the method for forming the heat radiation layer 1B is not particularly limited. Instead of forming the heat radiation layer by applying a heat radiation coating composition as described in the above embodiments, it is possible to form the heat radiation layer by performing a black alumite process or the like or by attaching a film having a high heat radiation capability.

### [Examples]

Next, the usefulness of the present invention will be described based on examples and comparative examples.

### [Manufacturing Example 1 of Heat Dissipating Sheet]

### <Synthesis of Polyamide Acid Varnish>

In a 1-litre four-neck flask equipped with an agitator and a thermometer, 73.2 g of 4,4'-diaminodiphenyl ether and 832 g of N-methyl-2-pyrrolidone were placed and heated to 50 °C under agitation for dissolution. Next, 40 g of pyromellitic anhydride and 51 g of biphenyl tetracarboxylic dianhydride were gradually added. After the addition was completed, the mixture was agitated for one hour. As a result, a polyamide acid varnish was obtained, in which aromatic polyamide acid represented by the following formula (I) is dissolved at a concentration of 16.5 wt.% in N-methyl-2-pyrrolidone.

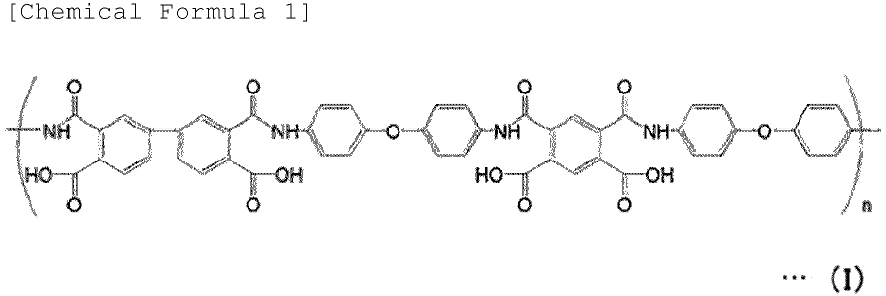

### <Preparation of Polyimide Heat Radiation Coating Composition>

3.0 g of talc ("Talc RA" available from Nippon Talc Co., Ltd.), 3.0 g of coal ash ("Clean Ash" available from Soma Kankyo Service Co., Ltd.), 0.2 g of carbon black ("MA-100" available from Mitsubishi Chemical Corporation), and 24.5 g of the polyamide acid varnish (4.0g of polyamide acid and 20.5 g of N-methyl-2-pyrrolidone) synthesized as described above were placed in a plastic airtight container and then agitated with a planetary centrifugal mixer ("ARE-310" available from Thinky Corporation) in a mixing mode (2000 rpm) for 10 minutes followed by agitation in a defoaming mode (2200 rpm) for 10 minutes. As a result, a uniform heat radiation coating composition was obtained in which the proportion of a water-insoluble inorganic compound (talc and coal ash) and a colorant (carbon black) was 60.8 wt.% relative to the entire nonvolatile components, and the proportion of the nonvolatile components was 33.2 wt.% relative to the entire dispersion.

### <Manufacture of Heat Dissipating Sheet>

The heat radiation coating composition thus obtained was applied to a 100µm-thick aluminum sheet with the use of a bar coater that had a groove having a depth of 200 µm. The heat radiation coating composition was dried in a forced air oven at 90°C for two hours while the aluminum sheet was held horizontally, whereby a heat radiation layer was formed on the aluminum sheet. The aluminum sheet was heated at 120°C for 30 minutes, at 150°C for 5 minutes, at 200°C for 5 minutes, at 250°C for 5 minutes, and at 350°C for 60 minutes in the stated order, thus obtaining an aluminum sheet having a 49.2-µm-thick heat radiation layer containing talc, coal ash, carbon black, and a polyimide resin in which the content of a water-insoluble inorganic compound (talc and carbon ash) and a colorant (carbon black) was 60.8 wt.% relative to the entire heat radiation layer.

### [Example 1]

### <Manufacture of Heat Sink>

The manufacture of a heat sink according to the present example will be described based on Figs. 1 to 4. A 300µm-thick aluminum sheet was cut to make a portion corresponding to the bottom plate (metal sheet 2) of the heat sink shown in Figs. 1 and 4. Next, a 100µm-thick aluminum sheet was cut and bent to make four members (intermediate members 3) shown in Fig. 3. Then, the aluminum sheet (heat dissipating sheet) having the heat radiation layer made by the above-described method was cut and bent to make the member (quasi-tubular shell 1) shown in Fig. 2. The bending was performed such that the heat radiation layer was arranged on the outer side. Next, these members were bonded to each other with a heat conductive double-sided tape (Tape No. 7055, available from Teraoka Seisakusho Co. Ltd.) to make the heat sink shown in Figs. 1 and 4.

### [Example 2]

### <Manufacture of Heat Sink>

The manufacture of a heatsink according to the present example will be described based on Figs. 5 to 7. The aluminum sheet having the heat radiation layer made in Manufacturing Example 1 was cut and bent to manufacture five quasi-tubular members (shell 1) shown in Fig. 6. The bending was performed such that the heat radiation layer was arranged on the outer side. A 300µm-thick aluminum sheet was cut to make a portion corresponding to the bottom plate (metal sheet 2) of the heatsink shown in Figs. 5 and 7. The tubular members shown in Fig. 6 were bonded to the bottom plate with a heat conductive double-sided tape (Tape No. 7055, available from Teraoka Seisakusho Co., Ltd.) to make the heat sink shown in Figs. 5 and 7.

### [Manufacturing Example 2 of Heat Dissipating Sheet]

### <Preparation of Epoxy Heat Radiation Coating Composition>

10 g of bisphenol A epoxy resin (available from Sumitomo Bakelite Co., Ltd.), 5.0 g of a curing agent (available from Sumitomo Bakelite Co., Ltd.), and 11.2 g of N-methyl-2-pyrrolidone were placed in a plastic container, and 18 g of Talc (5000PJ, Matsumura Sangyo Co., Ltd.) and 4.5 g of alumina (A-42-2, Showa Denko) were added. The mixture was then agitated with a planetary centrifugal mixer ("ARE-310" available from Thinky Corporation) in a mixing mode (2000 rpm) for 5 minutes and in a defoaming mode (2200 rpm) for 10 minutes. As a result, a uniform heat radiation coating composition was obtained in which the proportion of talc and alumina was 60.0 wt.% relative to the entire nonvolatile components.

### <Manufacture of Heat Dissipating Sheet>

The heat radiation coating composition thus obtained was applied to a 100-µm-thick aluminum sheet with the use of a bar coater that has a groove having a depth of 80 µm. The heat radiation coating composition was dried and thermally cured in a forced air oven at 90°C for 10 minutes and at 130°C for 20 minutes while the aluminum sheet was held horizontally, whereby an aluminum sheet having a 65-µm-thick heat radiation layer was obtained.

### [Example 3]

### <Manufacture of Heat Sink>

A heat sink having the configuration shown in Figs. 5 and 7 was manufactured in a similar manner to Example 2, except that the aluminum sheet manufactured in Manufacturing Example 2 was used as an aluminum sheet having a heat radiation layer.

### [Manufacturing Example 3 of Heat Dissipating Sheet]

### <Preparation of Acrylic Heat Radiation Coating Composition>

5.76 g of talc (5000 PJ, Matsumura Sangyo Co., Ltd.) and 1.44 g of alumina (A-42-2, Showa Denko K.K.) were added to 10 g of an acrylic resin emulsion (A-3611, solid content 48%, available from Toagosei Co., Ltd.) which was then agitated with a planetary centrifugal mixer ("ARE-310" available from Thinky Corporation) in a mixing mode (2000 rpm) for 5 minutes and in a defoaming mode (2200 rpm) for 3 minutes. As a result, a uniform heat radiation coating composition was obtained in which the proportion of talc and alumina was 61 wt.% relative to the entire nonvolatile components.

### <Manufacture of Heat Dissipating Sheet>

The heat radiation coating composition thus obtained was applied to a 100µm-thick aluminum sheet with the use of a bar coater that has a groove having a depth of 80 µm. The heat radiation coating composition was dried in a forced air oven at 90°C for 10 minutes while the aluminum sheet was held horizontally, whereby an aluminum sheet having a 50µm-thick heat radiation layer was obtained.

### [Example 4]

### <Manufacture of Heat Sink>

A heat sink having the configuration shown in Figs. 5 and 7 was manufactured in a similar manner to Example 2, except that the aluminum sheet manufactured in Manufacturing Example 3 was used as an aluminum sheet having a heat radiation layer.

### [Comparative Example 1]

A heat sink was manufactured in a similar manner to Example 1, except that a 100µm-thick aluminum sheet not having any heat radiation layer was used instead of the aluminum sheet having the heat radiation layer in Example 1.

### [Comparative Example 2]

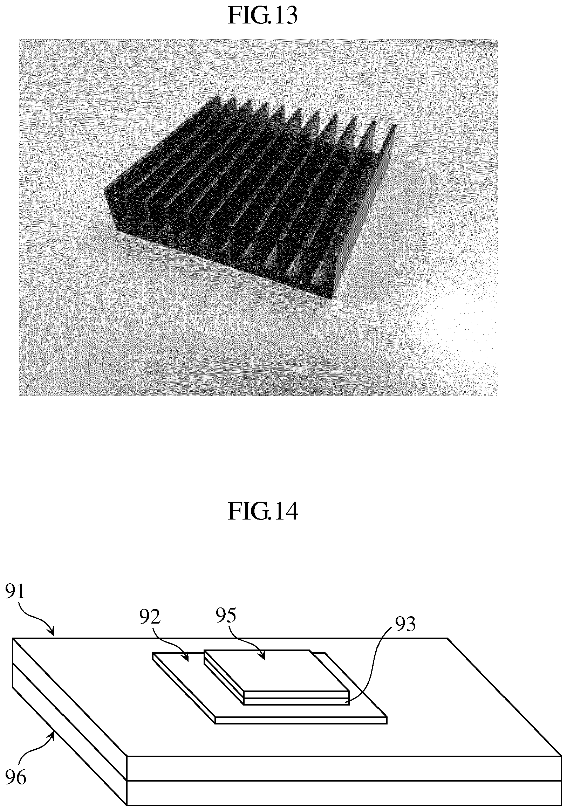

As a heat sink, a heat sink 12F51L50 (51 × 50 × 12, 11 pins, 39 g, subjected to alumite treatment) available from LSI Cooler Co., Ltd., which was formed by performing extrusion molding on aluminum as shown in Fig. 13, was prepared.

### <Evaluation of Cooling Performance>

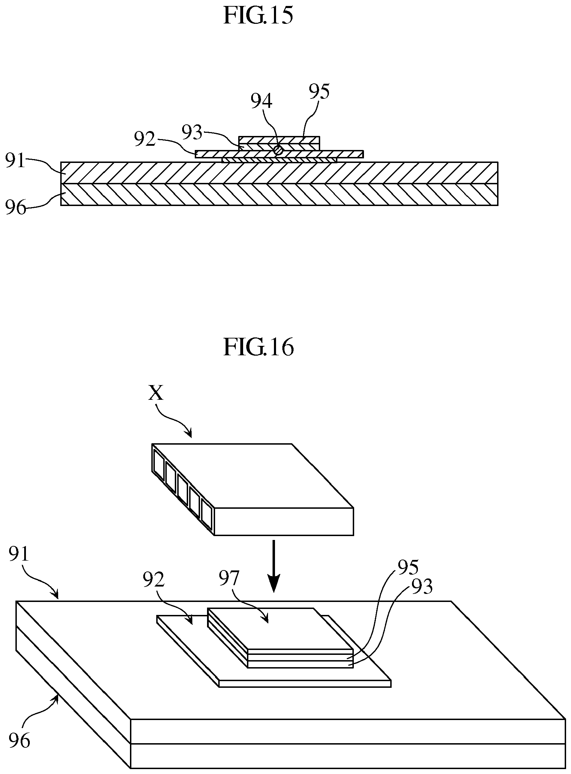

The heat sinks in Examples 1-4 and Comparative Examples 1-2 were measured for their cooling performance. In measurement, a ceramic heater ("BPC 10", available from BI Technologies Japan Co., Ltd.) (hereinafter, simply "heater 93") having a size of 2.4 cm square and a thickness of 0.5 to 1.5 mm as mounted on a substrate 92 ("MODEL ICB-88G" available from Sunhayato Co., Ltd.) was placed on a glass plate 91, as shown in Figs. 14 and 15. A thermocouple 94 was adhered to a reverse surface of the heater 93. A sheathed electric wire was soldered to an end of the heater 93, whereby the heater was connected to a stabilized DC power supply ("AD-8724D" available from A&D Co., Ltd.) not shown in figures. In order to avoid contact between the above-described soldered portion and the heat sink, an aluminum plate 95 (thickness of 1 mm) having the same area as the heater 93 was placed thereon, and foamed polystyrene 96 was fixed to the underside of the glass plate 91 to serve as a heat insulating material. Such a measurement device was installed vertically, and the output current of the stabilized DC power supply was adjusted. 3W power was input to the heater 93 and the temperature (temperature (A)) in equilibrium was measured by a data logger. The measured temperature was the one when there was no heat sink.

Next, as shown in Fig. 16, each heat sink X was disposed over the heater 93 on which the aluminum plate 95 was placed, with a silicone rubber 97 (available from Shin-Etsu Silicones Co., Ltd, TC-HSV-1.4, a thickness of 500 µm, 20 mm × 20 mm) interposed between the heat sink and the aluminum plate . Then, the measurement device was installed vertically, and a temperature in equilibrium (heat sink installed equilibrium temperature (B)) was measured. The temperature difference (A - B) between the temperature (A) and the temperature (B) was evaluated as cooling performance. A larger temperature difference suggests a higher cooling performance. The measurement results are shown in Table 1.

**[Table 1]**

| | Size | Weight | Temperature (A) | Temperature (B) | Temperature difference (A - B) |
|---|---|---|---|---|---|
| Example 1 | Height 50 mm × Width 50 mm × Depth 12 mm | 5.2 g | | 62.7 °C | 90.3 °C |
| Example 2 | | 5.6 g | | 59.9 °C | 93.1 °C |
| Example 3 | | 6.5 g | | 61.7 °C | 91.3 °C |
| Example 4 | | 5.9 g | | 61.7 °C | 91.3 °C |
| Comparative Example 1 | | 4.2 g | | 68.3 °C | 84.7 °C |
| Comparative Example 2 | | 38.4 g | | 61.0 °C | 92.0 °C |
| No Heat Sink | | | 153.0 °C | | |

The results in Examples 1 and 2 and Comparative Example 2 demonstrate that the heat sink of the present invention has cooling performance equivalent to or greater than the heat sink manufactured through extrusion molding even though it weighs approximately 1/7 of the heat sink manufactured through extrusion molding. It is also clear from Comparative Example 1 and Example 1 that the heat sink of the present invention has higher cooling performance than the heat sink made only of aluminum foil.

### [LIST OF REFERENCE SIGNS]

- X, X1, X2, X3, X4: Heat sink
- 1: Shell
- 1A: Heat transfer layer
- 1B: Heat radiation layer
- 11: Bent portion
- 12: Upright portion
- 13: Ceiling portion
- 2, 3: Metal sheet
- 91: Glass plate
- 92: Substrate
- 93: Heater
- 94: Thermocouple
- 95: Aluminum Plate
- 96: Foamed polystyrene
- 97: Silicone rubber
- O1: Cooling target

## Claims

1. A heat sink comprising:
a shell attached to a cooling target, and having an inner space defined by a heat dissipating sheet, the heat dissipating sheet having a heat transfer layer and a heat radiation layer laminated on the heat transfer layer, wherein
the heat radiation layer constitutes at least a portion of an outer surface of the shell located away from the cooling target.

2. The heat sink according to claim 1, further comprising a metal sheet interposed between the cooling target and the shell.

3. The heat sink according to claim 2, wherein the metal sheet comprises a flat plate.

4. The heat sink according to any of claims 1 to 3, further comprising an intermediate member interposed between the cooling target and the shell.

5. The heat sink according to claim 4, wherein the intermediate member comprises a channel member.

6. The heat sink according to claim 5, wherein the intermediate member comprises a corrugated plate.

7. The heat sink according to any of claims 1 to 6, wherein
the heat transfer layer is a metal layer, and
the heat radiation layer contains a water-insoluble inorganic compound and a heat-resistant synthetic resin, and a content of the water-insoluble inorganic compound in the heat radiation layer is 30 to 90 wt.% relative to the entire heat radiation layer.

8. The heat sink according to claim 7, wherein the metal layer contains aluminum and/or copper.

9. The heat sink according to claim 7 or 8, wherein the water-insoluble inorganic compound is at least one selected from the group consisting of silica compounds, silica alumina compounds, aluminum compounds, calcium compounds, nitrides, phyllosilicates, and coal ash.

10. The heat sink according to any of claims 7 to 9, wherein the heat-resistant synthetic resin is at least one selected from the group consisting of polyimide resins, polyamide-imide resins, epoxy resins, and acrylic resins.

11. A cooling structure comprising a cooling target, and the heat sink according to any of Claims 1 to 10, the heat sink being attached to the cooling target.
